(19) Europäisches Patentamt
European Patent Office
Office européen des brevets

(11) Veröffentlichungsnummer: **0 667 560 A1**

(12) # EUROPÄISCHE PATENTANMELDUNG

(21) Anmeldenummer: **95101221.0**

(22) Anmeldetag: **30.01.95**

(51) Int. Cl.[6]: **G03F 7/027**, G03F 7/34, C09D 4/00

(30) Priorität: **11.02.94 DE 4404372**

(43) Veröffentlichungstag der Anmeldung: **16.08.95 Patentblatt 95/33**

(84) Benannte Vertragsstaaten: **BE DE FR GB NL**

(71) Anmelder: **Agfa-Gevaert AG**
**Kaiser-Wilhelm-Allee**
**D-51373 Leverkusen (DE)**

(72) Erfinder: **Podszun, Wolfgang, Dr.**
**Roggendorfstrasse 55**
**D-51061 Köln (DE)**
Erfinder: **Heiliger, Ludger, Dr.**
**Carl-Rumpff-Strasse 8**
**D-51373 Leverkusen (DE)**
Erfinder: **Müller, Michael Dr.**
**Richard-Zanders-Strasse 34**
**D-51469 Bergisch Gladbach (DE)**
Erfinder: **Casser, Carl, Dr.**
**Wolfskaul 7**
**D-51061 Köln (DE)**
Erfinder: **Uytterhoeven, Herman, Dr.**
**Boflaan 6**
**B-2820 Bonheiden (BE)**
Erfinder: **van Damme, Marc**
**Niddelweg 46,**
**Bus 32**
**B-3001 Hewerlee (BE)**

(54) **Bilderzeugungsverfahren auf Basis von Fotopolymerisation und Delamination.**

(57) Bilderzeugungsverfahren; ein Bilderzeugungselement mit einer auf einen Schichtträger aufgetragenen fotopolymerisierbaren Schicht wird bildmäßig einer aktinischen Belichtung ausgesetzt, wodurch die bildmäßig belichteten Teile der fotopolymerisierbaren Schicht ganz oder teilweise gehärtet werden, die nicht oder unzureichend gehärteten Teile der fotopolymerisierbaren Schicht werden von den gehärteten Teilen dieser Schicht durch einen Delaminationsprozeß getrennt, die fotopolymerisierbare Schicht enthält ein fotopolymerisierbares Monomer der Formel I

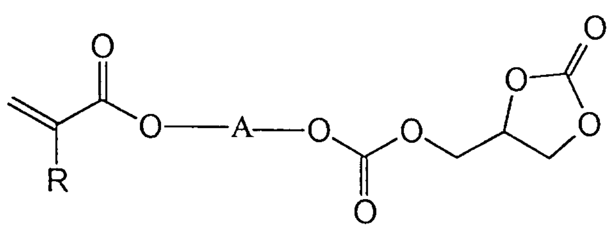

(I)

worin

A ein 2-wertiger Kohlenwasserstoffrest mit 2 bis 33 C-Atomen ist, der bis zu 16 Etherbrücken enthalten kann, und R für H oder Methyl steht.

EP 0 667 560 A1

Die vorliegende Erfindung betrifft ein Bilderzeugungsverfahren, bei dem ein Bilderzeugungselement mit einer auf einen Schichtträger aufgetragenen fotopolymerisierbaren Schicht, enthaltend ein (Meth)acrylat mit einer cyclischen Carbonatgruppe, bildmäßig belichtet und durch Delamination entwickelt wird.

Aufzeichnungsmaterialien auf Basis von Methacrylaten und Acrylaten sind gut bekannt. Bei diesen Aufzeichnungsmaterialien wird durch bildmäßige Belichtung mit aktinischer Strahlung eine Fotopolymerisation ausgelöst. Die Abbildungsmethoden beruhen auf dem Prinzip, eine Differenzierung der Eigenschaften der belichteten und nicht belichteten Teile der fotopolymerisierbaren Schicht zu erzeugen, beispielsweise eine Differenzierung hinsichtlich Löslichkeit, Adhäsion, Leitfähigkeit, Brechungsindex, Klebrigkeit, Permeabilität oder Diffussionsfähigkeit von eindringenden Substanzen, wie z.B. Farbstoffen.

Abbildungssyteme, die auf einer Differenzierung der Klebrigkeit beruhen, werden in den US-Patentschriften 3 060 024, 3 085 488 und 3 649 268 beschrieben. Entsprechend der in diesen Patentschriften offenbarten Methode verliert die fotopolymerisierbare Schicht im Bereich der bildmäßig belichteten Stellen ihre Klebrigkeit, während die unbelichteten Stellen klebrig bleiben. Die nicht belichteten Stellen können daher mit trockenen Pigmenten angefärbt werden, um das Bild sichtbar zu machen.

Weitere Abbildungsmethoden, die auf der Fotopolymerisation mit anschließender Trockenentwicklung beruhen, werden in US-A-3 245 796, EP-A-0 362 827, US-A-4 587 198 und US-A-3 060 023 beschrieben.

Wie vorstehend ausgeführt, wird die Fotopolymerisation in vielfältiger Weise zur Bildwiedergabe genutzt. Dabei werden Methoden sowohl mit nasser als auch mit trockener Bildentwicklung angewendet. Letztere sind besonders anwendungsfreundlich und weisen entscheidende ökologische Vorteile auf. Allerdings ist die optische Auflösung, die mit trockenentwickelbaren fotopolymerisierbaren Zusammensetzungen erzielt werden kann, relativ niedrig. Die niedrige Auflösung ist ein besonderes Problem bei der Wiedergabe von fein gerasterten Bildern. Darüber hinaus ist die energetische Empfindlichkeit der bekannten trockenentwickelbaren Materialien relativ gering.

Die EP-A-0 406 057 schlägt die Verwendung von (Meth)acrylaten mit cyclischen Carbonatgruppen für Beschichtungen vor.

In Makromol. Chem. **192**, 507-522 (1991) wird u.a. die Copolymerisation von (Meth)acrylaten mit cyclischen Carbonatgruppen mit bifunktionellen Oligomeren beschrieben.

Der vorliegenden Erfindung liegt die Aufgabe zugrunde, ein trockenes, ökologisch vorteilhaftes Bilderzeugungsverfahren bereitzustellen, das sich durch hohe Empfindlichkeit auszeichnet und Bilder mit hoher Bildqualität, insbesondere mit hoher Auflösung, hoher Randschärfe und hoher Empfindlichkeit liefert. Weitere Aufgaben der vorliegenden Erfindung ergeben sich aus der nachfolgenden Beschreibung.

Gegenstand der Erfindung ist ein Bilderzeugungsverfahren, bei dem ein Bilderzeugungselement mit einer auf einen Schichtträger aufgetragenen fotopolymerisierbaren Schicht bildmäßig einer aktinischen Belichtung ausgesetzt wird, wodurch die bildmäßig belichteten Teile der fotopolymerisierbaren Schicht ganz oder teilweise gehärtet werden, und bei dem die nicht oder unzureichend gehärteten Teile von den gehärteten Teilen der fotopolymerisierbaren Schicht durch einen Delaminationsprozeß getrennt werden, dadurch gekennzeichnet, daß die fotopolymerisierbare Schicht ein fotopolymerisierbares Monomer der Formel I enthält,

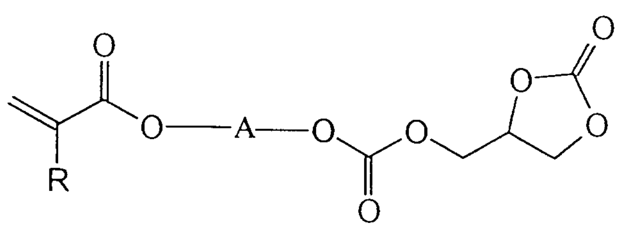
(I)

worin bedeuten

A  einen 2-wertigen Kohlenwasserstoffrest mit 2 bis 33 C-Atomen, der bis zu 16 Etherbrücken enthalten kann;

R  H oder Methyl ist.

Beispiele für geeignete Kohlenwasserstoffreste A sind:
lineare oder verzweigte Alkylenreste mit 2 bis 32, vorzugsweise 2 bis 6 C Atomen;

$-(CH_2-CH_2-O)_n-CH_2-CH_2-$, mit n = 1 bis 15;
$-(CH_2-CH_2-CH_2-CH_2-O)_n-CH_2-CH_2-CH_2-CH_2-$, mit n = 1 bis 7;
$-(CH_2-CH[CH_3]-O)_n-CH_2-CH[CH_3]-$, mit n = 1 bis 10.

Selbstverständlich kommen auch Kohlenwasserstoffreste A in Frage, bei denen n ein statistisches Mittel aus verschieden langen Alkylenoxidresten darstellt.

In der nachfolgenden Tabelle 1 werden besonders gut geeignete Monomere angegeben.

| | |
|---|---|
| Monomer 1 | 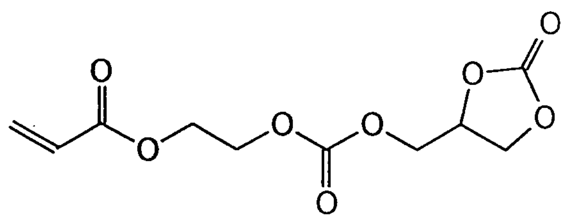 |
| Monomer 2 | 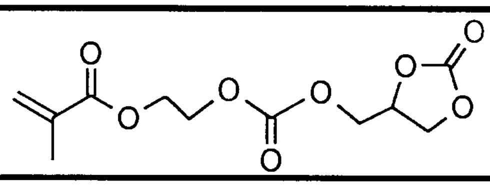 |
| Monomer 3 | 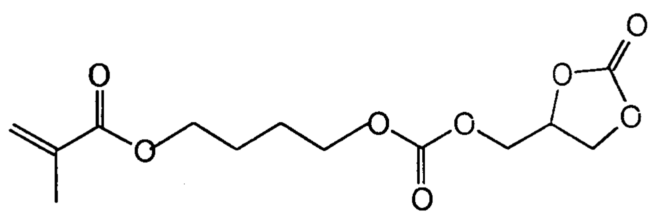 |
| Monomer 4 | 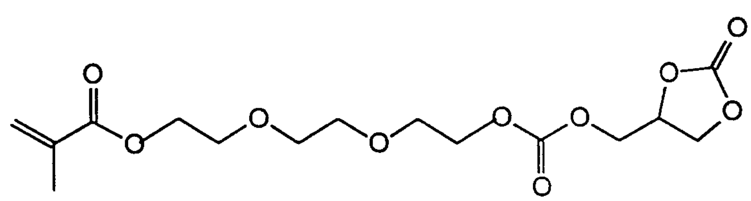 |
| Monomer 5 | 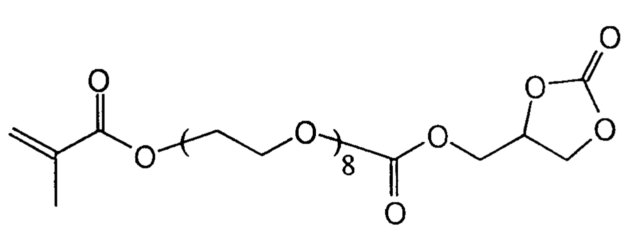 |

Die Synthese der (Meth)acrylate mit cyclischen Carbonatgruppen erfolgt zweckmäßigerweise durch Umsetzung des zugrundeliegenden Hydroxyalkyl(meth)acrylates mit dem Chlorameisensäureester gemäß Formel II

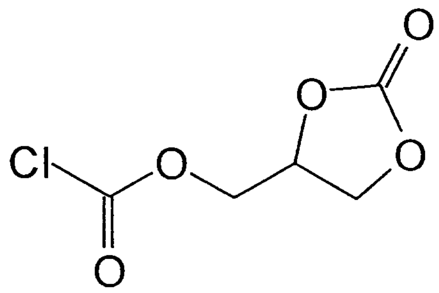

(II)

Der Chlorameisensäureester gemäß Formel II kann durch Phosgenierung von Glycerin hergestellt werden. Dieser Syntheseschritt wird in US-A-2 446 145 ausführlich beschrieben.

Das erfindungsgemäße Bilderzeugungsverfahren basiert auf einem Bilderzeugungselement mit einer auf einem Schichtträger aufgetragenen fotopolymerisierbaren Schicht.

Die fotopolymerisierbare Schicht kann neben den Monomeren der Formel I weitere Monomere und/oder Polymere mit reaktiven Doppelbindungen enthalten, die nicht unter die Formel I fallen. Beispielhaft seien genannt: Ethylenglycoldiacrylat, Diethylenglycoldiacrylat, Triethylenglycoldiacrylat, Tetraethylenglycoldiacrylat, Butandiacrylat- 1,4, Hexamethylendiacrylat, Cyclohexandimethacrylat, Glycerindiacrylat, Glycerintriacrylat, Trimethylolpropantriacrylat, Pentaerythritoltriacrylat, Pentaerythritolttetraacrylat, Dipentaerythritolpentaacrylat und Dipentaerythritolhexaacrylat, sowie die entsprechenden Methacrylate. Weitere geeignete Monomere sind sogenannte Epoxyacrylate wie z.B. Bisphenol-A-diglycidyldimethacrylate und Urethanacrylate, die durch Umsetzung von (Poly)isocyanaten mit Hydroxyalkyl(meth)acrylaten erhalten werden können. Besonders gut geeignet sind Urethanacrylate gemäß EP-A-0 502 562 und europäischer Patentanmeldung Nr. 92 202 631, angemeldet am 31.08.92. Beispiele für Polymere mit reaktiven Doppelbindungen sind Polyester und Polyurethane mit end- und/oder seitenständigen (Meth-)acrylatgruppen; ferner Umsetzungsprodukte von Polyvinylalkohol mit Methacrylsäure.

Der Anteil an Monomeren gemäß Formel I sollte 5 - 100 %, vorzugsweise 10-100 %, bezogen auf die Summe aller Monomeren, betragen.

Die fotopolymerisierbare Schicht enthält mindestens einen Fotoinitiator. Als Fotoinitiatoren werden insbesondere Polymerisationsinitiatoren verwendet, die bei Temperaturen unterhalb von 185C thermisch inaktiv und durch aktinisches Licht aktivierbar sind. Beispiele solcher Initiatoren schließen substituierte und unsubstituierte vielkernige Chinone ein, d.h. Verbindungen mit zwei an Ring-Kohlenstoffatome in einem konjugierten sechsgliedrigen carbocyclischen Ring gebundenen Carbonylgruppen, wobei wenigstens ein aromatischer carbocyclischer Ring an den die Carbonylgruppen tragenden Ring ankondensiert ist. Solche Initiatoren schließen beispielsweise ein: 9,10-Anthrachinon, 1-Chloranthrachinon, 2-Chloranthrachinon, 2-Methylanthrachinon, 2-tert.-Butylanthrachinon, Octamethylanthrachinon, 1,4-Naphthochinon, 9,10-Phenanthrenchinon, 1,2-Benzanthrachinon, 2,3-Dichlornaphthochinon, das Natriumsalz von Anthrachinon-$\alpha$-sulfonsäure, 3-Chlor-2-methylanthrachinon und 1,2,3,4-Tetrahydrobenzo[a]-anthracen-7,12-dion. Weitere brauchbare Fotoinitiatoren sind beschrieben in US-A-2 760 863 und schließen vicinale Ketaldonylverbindungen ein wie Diacetyl, Benzil, $\alpha$-Ketaldonylalkohole wie Benzoin, Pivalon, Acyloinether wie beispielsweise Benzoinmethyl- und - ethylether; $\alpha$-kohlenwasserstoffsubstituierte aromatische Acyloine einschließlich Methylbenzoin, $\alpha$-Allylbenzoin und $\alpha$-Phenylbenzoin. Weitere geeignete Fotoinitiatoren sind beschrieben in "Photoreactive Polymers" von Arnost Reiser, in "Organic photochemical imaging systems" von G.A. Delzenne, in "UV-Curing Chemistry: Past, Present, and Future" von Christian Decker, veröffentlicht in Journal of Coatings Technology, Vol. 59, Nr. 751, August 1987, Seiten 97-106, sowie in EP-A-0 362 827 und US-A-3 558 309.

Gemäß vorliegender Erfindung kann die fotopolymerisierbare Schicht auch Polymerisationsinhibitoren enthalten. Geeignete Inhibitoren sind beispielsweise p-Methoxyphenol, Hydrochinon, alkyl- und acylsubstituierte Hydrochinone und Chinone, tert.-Butylbrenzkatechin, Pyrogallol, Kupferverbindungen, Naphthylamine -Naphthol, Kupfer-II-chlorid, 2,6-Bis-tert.-butyl-p-cresol, Fotothiazin, Pyridin, Nitrobenzol und Dinitrobenzol, p-Toluchinon und Chloranil.

In vielen Fällen ist es zweckmäßig, eine fotopolymerisierbare Schicht zu verwenden, die zusätzlich ein oder mehrere thermoplastische Polymere enthält. Das thermoplastische Polymer hat eine Erweichungstemperatur von vorzugsweise 40 ° C bis 250 ° C.

Geeignete thermoplastische Polymere für die Verwendung in Zusammenhang mit vorliegender Erfindung schließen ein:

(A) Polyvinylchlorid und Copolymere, z.B. Polyvinylchlorid/Vinylacetat, Polyvinylchlorid/Vinylacetat/Vinylalkohol;

(B) Vinylidenchlorid-Copolymere, z.B. Vinylydenchlorid/Acrylnitril-, Vinylidenchlorid/Methacrylat- und Vinylidenchlorid/Vinylacetat-Copolymere;

(C) Polyvinylester, z.B.Polyvinylacetat, Polyvinylacetat/Acrylat, Polyvinylacetat/Methacrylat;

(D) Polyacrylate und Polymethacrylate, z.B. Polymethylmethacrylat;

(E) Polystyrol und Copolymere, z.B. Polystyrol/Acrylnitril, Polystyrol/Acrylnitril/Butadien, Polystyrol/Acrylat:

(F) Ethylen/Vinylacetat-Copolymere;

(G) Polyvinylacetal, z.B. Polyvinylbutyral, Polyvinylformal;

(H) Synthetische Kautschuke z.B. Butadien/Acrylnitril-Copolymere und Polymere aus 2-Chlor-1,3-butadien;

(I) Hochmolekulares Ethylenoxid mit durchschnittlichen Molekulargewichten von 4 000 bis 1 000 000;

(J) Polyformaldehyde;

(K) Polyester und Polyestergemische aus Alkandiolen und zwei oder mehr der Dicarbonsäuren Terephthalsäure, Isophthalsäure. Sebacinsäure und Hexahydrophthalsäure;

(L) Polyamide, z.B. N-Methoxymethylpolyhexamethylenadipamid;

(M) Polyurethane;

(N) Polycarbonate;

(O) Celluloseether, z.B. Methylcellulose, Ethylcellulose, Benzylcellulose;

(P) Celluloseester, z,B. Celluloseacetat, Celluloseacetatsuccinat, Celluloseacetatbutyrat, Cellulosenitrat.

Der fotopolymerisierbare Schicht können außerdem nicht thermoplastische polymere Verbindungen zugesetzt werden, um der Schicht bestimmte gewünschte Eigenschaften zu verleihen, z.B. zur Verbesserung der Haftung an dem ursprünglichen Träger oder nach Übertragung an einem Akzeptorelement, sowie zur Verbesserung der mechanischen oder chemischen Stabilität. Geeignete nicht thermoplastische Verbindungen schließen Polyvinylalkohol, Cellulose, wasserfreie Gelatine, Phenolharze und Melaminformaldehydharze ein. Falls gewünscht kann die fotopolymerisierbare Schicht auch nicht mischbare polymere oder nicht polymere organische oder anorganische Füllstoffe oder Verstärkungsmittel enthalten, die im wesentlichen bei den für die Belichtung verwendeten Wellenlängen transparent sind, z.B. organophile Siliciumverbindungen, Bentonite, Kieselsäure, pulverisiertes Glas, kolloidalen Kohlenstoff, sowie verschiedene Arten von Farbstoffen und Pigmenten in je nach den gewünschten Eigenschaften wechselnden Mengen. Die Füllstoffe sind für die Verbesserung der Festigkeit der Zusammensetzung, die Verminderung der Klebrigkeit und außerdem als Färbemittel geeignet.

Des weiteren können der fotopolymerisierbaren Schicht Mittel zur Verbesserung der Benetzbarkeit oder der Haftung zugesetzt werden. Geeignete Mittel sind beispielsweise Silicone, Silicium enthaltende Polymere, z.B. ein Poly(dimethylsiloxan)-polyether-Copolymer, Poly(dimethylsiloxan)-polyester, Silicium enthaltende oberflächenaktive Mittel, Fluor enthaltende Copolymere und Fluor enthaltende Netzmittel.

Das Bilderzeugungselement der vorliegenden Erfindung kann weitere Schichten enthalten, z.B. eine Schicht zur Verbesserung der Haftung der fotopolymerisierbaren Schicht am Schichtträger oder einer Strippingschicht. Es kann vorteilhaft sein, zwischen dem Schichtträger und der lichtempfindlichen fotopolymerisierbaren Schicht, an letztere unmittelbar angrenzend, eine funktionelle Zwischenschicht anzuordnen, die beispielsweise ein Polymer mit polymerisierbaren ethylenisch ungesättigten Gruppen enthält. Eine solche funktionelle Zwischenschicht ist beispielsweise in EP-A-0 522 616 beschrieben.

Die Herstellung des fotoempfindlichen Schicht kann zweckmäßiger Weise durch Gießen aus Lösungsmitteln, insbesondere organischen Lösungsmitteln, erfolgen. Beispiele für geeignete Lösungsmittel sind Chloroform, Dichlormethan, Aceton, Methylethylketon, Essigester, THF, Methyl-tert.-butylether. Bevorzugt wird Methylethylketon.

Entsprechend der vorliegenden Erfindung wird das Bilderzeugungselement in bildmäßiger Verteilung einer aktinischen Bestrahlung ausgesetzt, um es bildmäßig entsprechend der Verteilung der aktinischen Strahlung ganz oder teilweise zu härten. Es kann sich dabei um eine Kontaktbelichtung mit ultravioletter oder sichtbarer Strahlung, eine Belichtung mittels einer Kamera, eine zeilenweise Belichtung (scanning exposure) oder eine Laserbelichtung handeln. Als Lichtquelle können Tageslicht, Glühlampen, Quecksilberdampflampen, Halogenlampen, Xenonlampen, Fluoreszenslampen, lichtemittierende Dioden oder Laser verwendet werden. Natürlich ist darauf zu achten, daß das Emissionsspektrum der Lichtquelle und das wirksame Absorptionsspektrum des Fotoinitiators, gegebenenfalls unter Mitwirkung eines Spektralsensibilisators, einen nutzbaren Überlappungsbereich aufweisen.

Das durch Belichtung erhaltene Polymerbild wird durch einen Delaminationsprozeß in das für die jeweilige Anwendung gewünschte endgültige Bild überführt. Unter Delamination wird das Trennen des Bilderzeugungselementes von einem Donorelement oder einem als Hilfsmittel verwendeten Delaminationsmaterial verstanden. Die Delamination kann manuell oder mit Hilfe von Geräten erfolgen.

Das erfindungsgemäße Verfahren kann z.B. zur Herstellung von Schwarz-weiß-Bildern, Farbbildern und Druckplatten verwendet werden.

Zur Herstellung von Farbbildern werden beispielsweise mindestens drei Bilderzeugungselemente, die einen Gelbfarbstoff einen Magentafarbstoff und einen Cyanfarbstoff bzw. entsprechende Farbpigmente in oder unterhalb der fotopolymerisierbaren Zusammensetzung enthalten. bildmäßig mit einem gerasterten Blau-, Grün- oder Rot-Farbauszug der Vorlage belichtet. Gegebenenfalls kann auch ein viertes Bilderzeugungselement verwendet werden, das einen schwarzen Farbstoff oder ein Schwarzpigment enthält. Diese Bilderzeugungselemente werden nacheinander in der Wärme (z.B bei 50 -150 °C) mit einem Akzeptorelement, z.B. einem Papier, in Kontakt gebracht und anschließend delaminiert. Bei diesem Vorgang werden die nicht gehärteten Teile des Bildes auf das Akzeptorelement übertragen. Es liegt auf der Hand, daß der Übertrag der unterschiedlichen Farbauszüge paßgenau erfolgen muß, um eine farbgetreue Reproduktion des ursprünglichen Bildes zu erhalten.

In einer besonderen Ausführungsform der vorliegenden Erfindung dient das Aufzeichnungsmaterial zur Herstellung von Druckplatten. Dabei kann das durch Belichtung erzeugte Polymerbild von einem Donorelement auf die Druckplattenunterlage übertragen werden oder direkt auf der Druckplattenunterlage erzeugt werden.

Als Unterlagen für Druckplatten dienen Träger mit hydrophilen Oberflächen, beispielsweise Metallträger wie Aluminium oder Zink, Polyesterfilm oder Papierunterlagen.

Diese Träger können, falls sie nicht selbst ausreichend hydrophil sind, zuerst mit einer hydrophilen Schicht beschichtet werden. Eine besonders geeignete hydrophile Schicht ist eine Schicht aus Polyvinylalkohol, die mit einem Tetraorthosilikat, z.B. einem $TiO_2$ enthaltenden Tetramethylorthosilikat oder Tetraethylorthosilikat, gehärtet wurde wie beispielsweise beschrieben in US-A-3 971 660.

Ein besonders geeigneter Metallträger ist Aluminium. Geeignete Aluminiumträger für die Verwendung gemäß vorliegender Erfindung sind Aluminiumfolien aus Reinaluminium oder einer Aluminiumlegierung, deren Aluminiumgehalt wenigstens 95 % beträgt. Eine geeignete Legierung enthält beispielsweise 99,55 Gew.-% Aluminium, 0,29 Gew.-% Eisen, 0,10 Gew.-% Silizium, 0,004 Gew.-% Kupfer, 0,002 Gew.-% Mangan, 0,02 Gew.-% Titan und 0,03 Gew.-% Zink. Die Dicke einer solchen Folie liegt üblicherweise zwischen 0,13 und 0,5 mm.

Die Herstellung einer für den lithografischen Offsetdruck geeigneten Aluminium- oder Aluminiumlegierung-Folie umfaßt folgende Schritte: Aufrauhung, Anodisierung und gegebenenfalls Versiegelung.

Aufrauhung und Anodisierung der Folie sind notwendig, um gemäß vorliegender Erfindung hochqualitative Drucke zu ermöglichen. Versiegelung ist nicht notwendig, kann aber die Druckergebnisse weiter verbessern.

Aufrauhung der Aluminiumoberfläche kann mechanisch oder elektrolytisch in bekannter Weise durchgeführt werden. Die durch die Aufrauhung erreichte Rauheit wird in µm als Abweichung von einer Mittellinie gemessen und beträgt vorzugsweise ca. 0,2 bis 1,5 µm.

Die Anodisierung der Aluminiumfolie kann durchgeführt werden in elektrolytischen Bädern, z.B. Chromsäure, Oxalsäure, Natriumcarbonat, Natriumhydroxid und deren Mischungen. Bevorzugt wird die Anodisierung von Aluminium und verdünnter wäßriger Schwefelsäure durchgeführt, bis die erwünschte Dicke der Anodisierungsschicht erreicht ist. Die Aluminiumfolie kann auf beiden Seiten anodisiert werden. Die Dicke der Anodisierungsschicht wird genau bestimmt an einem Mikroschnitt, aber sie kann ebenso ermittelt werden durch Auflösung der Anodisierungsschicht und Wiegen der Folie vor und nach der Auflösungsbehandlung. Gute Ergebnisse werden erhalten, mit einer Anodisierungsschicht, die ungefähr von 0,4 bis ungefähr 2,0 µm beträgt. Zur Verbesserung der Bildschärfe und dementsprechend der Schärfe der Druckkopie kann die Anodisierungsschicht in der Masse eingefärbt sein mit einem Antihalo-Farbstoff oder Pigment wie beispielsweise beschrieben in JP-A-58-14797.

Nach der Anodisierungsbehandlung kann die anodische Oberfläche versiegelt werden. Versiegelung der Poren der bei der Anodisierung gebildeten Aluminiumoxidschicht ist eine bekannte Technik, die beispielsweise beschrieben ist in der "Belgisch-Nederlands tijdschrift voor Oppervlaktetechnieken van materialen", 24. Jahrgang/Januar 1980. Man kennt verschiedene Arten der Versiegelung von porösen, anodisierten Aluminiumoberflächen. Eine vorteilhafte Methode ist die Hydratationsversiegelung, bei der die Poren ganz oder teilweise durch Wasseraufnahme geschlossen werden, so daß sich hydratisierte nadelförmige Aluminiumoxidkristalle (Böhmit) bilden. Die anodisierte Oberfläche der Aluminiumfolie kann hierzu mit Wasser bei

70 bis 100°C oder mit Dampf behandelt werden. Das Wasser kann hierzu Zusätze enthalten, z.B. Nickelsalze, um den Versiegelungseffekt zu verbessern. Die Versiegelung kann auch durchgeführt werden durch Behandlung der anodischen Oberfläche mit einer wäßrigen Lösung von Phosphationen oder Silikaten. Aufgrund der Versiegelungsbehandlung wird die anodische Schicht im wesentlichen nicht porös gemacht, so daß sie für die Herstellung einer größeren Anzahl von Drucken geeignet sind. Als Ergebnis der Versiegelungsbehandlung kann das Auftreten von Schleier in den Nichtbild-Teilen der Druckplatte weitgehend vermieden werden.

Die Aufrauhung, die Anodisierung und die Versiegelungsbehandlung der Aluminiumfolie kann durchgeführt werden wie beispielsweise beschrieben in US-A-3 861 917.

Nach einer besonderen Ausführungsform des erfindungsgemäßen Verfahrens zur Herstellung einer Druckplatte wird das Bilderzeugungselement, das im wesentlichen aus einer fotoempfindlichen Schicht, die die erfindungsgemäßen Monomeren enthält, und einem Trägermaterial, beispielsweise einer Polyethylenterephthalatfolie, besteht, bildmäßig belichtet und als Donorelement mit einer hydrophilen Druckplattenunterlage als Akzeptorelement mit Hilfe eines Rollenlaminators bei erhöhter Temperatur in Kontakt gebracht; dabei findet eine bildmäßige Übertragung der nicht-polymerisierten Anteile vom Donorelement auf das Akzeptorelement statt. Danach werden Donor- und Akzeptorelement delaminiert, wodurch ein Monomerbild auf der Druckplattenunterlage erhalten wird. Dieses Monomerbild ist als Druckform geeignet. Besonders stabile Druckformen erhält man, wenn das Monomerbild durch integrale Belichtung oder Erwärmung in ein Polymerbild überführt wird.

Nach einer weiteren Ausführungsform des erfindungsgemäßen Verfahrens zur Herstellung von Druckplatten ist die Unterlage des Bilderzeugungselementes selbst die Druckplattenunterlage. In diesem Falle wird das Bilderzeugungselement nach Belichtung, in der Wärme bei 50 - 150°C mit einen, Delaminationsmaterial in Kontakt gebracht, wobei das Inkontaktbringen in einfacher Weise mit Hilfe eines beheizbaren Rollenlaminators erfolgen kann. Nach der Delamination bleibt ein polymeres Bild auf der Druckplatte zurück, welche ohne weitere Nachbehandlungsschritte als Druckform verwendet werden kann. Die Platte kann aber auch nachbehandelt werden, z.B. durch Erwärmen, Belichten, Bestrahlen, um die Haftung und Kratzfestigkeit des erzeugten Polymerbildes zu verbessern. Als Delaminationsmaterialien eignen sich Folien, z.B. Polyethylenterephthalatfolien oder Papiere. Bei Anwendung dieser Ausführungsform der vorliegenden Erfindung hat es sich als besonders günstig erwiesen, als oberste Schicht auf dem Bilderzeugungsmaterial oder auf dem Delaminationsmaterial eine Schicht aus einem thermoplastischen Polymer anzubringen. Als thermoplastisches Polymer eignen sich die oben angegebenen Materialien.

Bilderzeugungselement und Delaminationsmaterial können auch vor der Belichtung in Kontakt gebracht werden oder als einheitliches Element vorliegen. Ein solches Element wird als Monosheet-Material bezeichnet und setzt voraus, daß die Unterlage und/oder das Delaminationsmaterial für die zur Belichtung der fotopolymerisierbaren Schicht verwendete Strahlung transparent sind.

Das erfindungsgemäße Bilderzeugungsverfahren ist leicht handhabbar und besonders umweltfreundlich. Die energetische Empfindlichkeit ist besonders hoch. Die erhaltenen Bilder sind schleierfrei und zeigen eine hohe Bildqualität, insbesondere eine hohe Auflösung und gute Kantenschärfe.

## Beispiele

### Beispiel 1

Herstellung von Monomer 5 aus Tabelle 1

In 87,5 ml Methylenchlorid wurden unter Stickstoffatmosphäre 71,75 g Blemmer PE 350 der Firma Nippon Oil sowie 13,12 g Pyridin gelöst und die Lösung wurde auf O°C gekühlt. Danach wurden 25 g Chlorameisensäureester der Formel II, gelöst in 37,5 g Methylenchlorid langsam zudosiert und der Ansatz wurde noch 2 h bei Raumtemperatur nachgerührt. Der entstandene Niederschlag wurde abfiltriert und das Filtrat auf das doppelte Volumen Wasser gegossen. Die organische Phase wurde abgetrennt, 2 mal mit 0,1 n Salzsäure, dann mit Natriumhydrogen-carbonatlösung ausgeschüttelt, schließlich mit Wasser gewaschen und über Natriumsulfat getrocknet. Nach Filtration und Abdampfen des Lösemittels verbleiben 62 g Monomer 5 aus Tabelle 1.

IR [$cm^{-1}$]: 1820 (cycl. Carbonat); 1760 (Carbonat); 1725 (Ester); 1645 (Methacryl)

**Beispiel 2**

Herstellung einer hydrophilen Druckplattenunterlage

Zu 418 g einer Dispersion von 21,5 Gew.-% $TiO_2$ (durchschnittliche Teilchengröße 0.3 bis 0.5 µm) und 2.5 Gew.-% Polyvinylalkohol in entionisiertem Wasser wurden unter Rühren nacheinander zugefügt:
220 g 5-%ige Lösung aus Polyvinylalkohol in Wasser
95 g hydrolysierte 22%ige Emulsion von Tetramethylorthosilikat in Wasser
22 g 10 %ige Lösung des Netzmittels Erkantol
Zu dieser Mischung wurde anschließend 245 ml entionisiertes Wasser zugefügt und der pH mit HCl auf 4 eingestellt. Diese Dispersion wurde auf eine 175 µm dicke PET-Folie mit einer Naßschichtdicke von 50 µm aufgetragen und bei 30 ° C getrocknet.

**Beispiel 3**

Herstellung einer Offset-Druckplatte

a) Herstellung eines lichtempfindlichen Bilderzeugungselementes als Donorelement

Es wurde eine Lösung aus folgenden Komponenten hergestellt:
1,6 g Bisimidazol
0,05 g Michlers Keton
0,1 g Mercaptobenzoxazol
1,68 g Verbindung M-7 aus Beispiel 1 in DE-A-41 29 284 (hergestellt durch Umsetzung von 0,1 Mol Isocyanurat des Hexamethylendiisocyanats (Desmodur® N 3300 der Bayer AG) mit 0,3 Mol Glycerindimethacrylat)
0,42 g Monomer 1 aus Tabelle 1
26,15 g 2-Butanon
Diese Lösung wurde mit einem Rakel mit der Spaltbreite 30 µm auf eine 100 µm dicke PET-Folie als Unterlage aufgegossen Nach der Trocknung ergab sich eine Auftragung von 3,85 g/m$^2$.

Das Donorelement wurde mit einer transparenten Testvorlage mit einem Strichmuster von 150 Linien pro Zoll in Kontakt gebracht und durch die Testvorlage mit UV-Licht belichtet.

Das belichtete Donorelement wurde dann in beschichtungsseitigem Kontakt mit der hydrophilen Druckplattenunterlage aus Beispiel 2 als Akzeptorelement bei 95 ° C und mit einer Geschwindigkeit von 950 mm/min durch eine Rollenlaminatorvorrichtunggeführt. Anschließend wurden beide Elemente getrennt. Die hydrophile Unterlage, die nun mit dem lichtempfindlichem Monomer in bildmäßiger Verteilung beschichtet war, wurde integral mit UV-Licht belichtet. Mit der auf diese Weise erhaltenen Druckplatte konnte in einer konventionellen Offset-Druckvorrichtung mit herkömmlicher Tinte gedruckt werden. Es wurden Drucke mit guter Qualität (hohe Auflösung, genaue Punktwiedergabe, gute Kantenschärfe) erhalten.

**Beispiel 4**

Herstellung einer Offset-Druckplatte

a) Herstellung eines lichtempfindlichen Bilderzeugungselementes als Donorelement

Es wurde eine Lösung aus folgenden Komponenten hergestellt:
1,6 g Bisimidazol
0,05 g Michlers Keton
0,1 g Mercaptobenzoxazol
0,42 g Monomer 5 aus Tabelle 1
1,68 g Verbindung M-7 aus Beispiel 1 in DE-A-41 29 284
26,15 g 2-Butanon
Diese Lösung wurde mit einem Rakel mit der Spaltbreite 30 µm auf eine 100 µm dicke PET-Folie als Unterlage aufgegossen. Nach der Trocknung ergab sich eine Auftragung von 3,85 g/m$^2$.

Das Donorelement wurde mit einer transparenten Testvorlage mit einem Strichmuster von 150 Linien pro Zoll in Kontakt gebracht und durch die Testvorlage mit UV-Licht belichtet.

Das belichtete Donorelement wurde dann in beschichtungsseitigem Kontakt mit der hydrophilen Druckplattenunterlage aus Beispiel 2 als Akzeptorelement bei 95 °C und mit einer Geschwindigkeit von 950 mm/min durch eine Rollenlaminatorvorrichtung geführt. Anschließend wurden beide Elemente getrennt. Die hydrophile Unterlage, die nun mit dem lichtempfindlichem Monomer in bildmäßiger Verteilung beschichtet war, wurde integral mit UV-Licht belichtet. Mit der auf diese Weise erhaltenen Druckplatte konnte in einer konventionellen Offset-Druckvorrichtung mit herkömmlicher Tinte gedruckt werden. Es wurden Drucke mit guter Qualität (hohe Auflösung, genaue Punktwiedergabe, gute Kantenschärfe) erhalten.

**Patentansprüche**

1. Bilderzeugungsverfahren, bei dem ein Bilderzeugungselement mit einer auf einen Schichtträger aufgetragenen fotopolymerisierbaren Schicht bildmäßig einer aktinischen Belichtung ausgesetzt wird. wodurch die bildmäßig belichteten Teile der fotopolymerisierbaren Schicht ganz oder teilweise gehärtet werden, und bei dem die nicht oder unzureichend gehärteten Teile von den gehärteten Teilen der fotopolymerisierbaren Schicht durch einen Delaminationsprozeß getrennt werden. dadurch gekennzeichnet daß die fotopolymerisierbare Schicht ein fotopolymerisierbares Monomer der Formel I

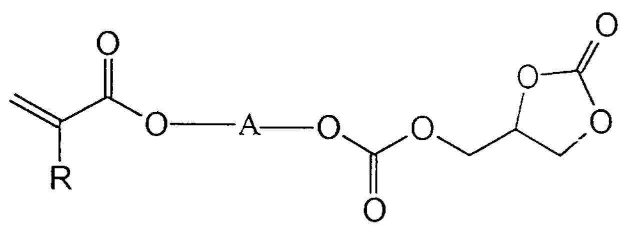 (I)

enthält,
worin bedeuten:
   - A einen 2-wertigen Kohlenwasserstoffrest mit 2 bis 33 C-Atomen, der bis zu 16 Etherbrücken enthalten kann.
   - R H oder Methyl.

2. Bilderzeugungsverfahren nach Anspruch 1 zur Herstellung von Druckplatten.

3. Fotopolymerisierbares Monomer der Formel I

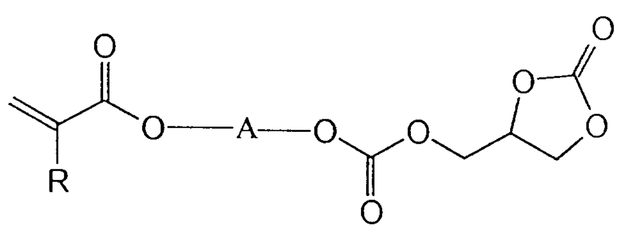 (I)

worin bedeuten
   - A einen 2-wertigen Kohlenwasserstoffrest mit 8 bis 33 C-Atomen, der 3 bis 16 Etherbrücken enthält,
   - R H oder Methyl.

Europäisches Patentamt

# EUROPÄISCHER RECHERCHENBERICHT

Nummer der Anmeldung
EP 95 10 1221

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.6) |
|---|---|---|---|
| Y,D | DE-A-14 47 030 (E.I. DU PONT DE NEMOURS AND COMPANY ) 16.Januar 1969<br>* Seite 6, Zeile 1 - Zeile 9; Anspruch 1 *<br>--- | 1,2 | G03F7/027<br>G03F7/34<br>C09D4/00 |
| Y,D | EP-A-0 406 057 (SOCIETE NATIONALE DES POUDRES ET EXPLOSIFS) 2.Januar 1991<br>* Seite 4, Zeile 50 - Zeile 54 *<br>* Seite 5, Zeile 1 - Zeile 9 *<br>--- | 1,2 | |
| A | EP-A-0 232 721 (FUJI PHOTO FILM CO.) 19.August 1987<br>* Seite 13, Zeile 13 - Zeile 36; Anspruch 1 *<br>----- | 1-3 | |
| | | | **RECHERCHIERTE SACHGEBIETE (Int.Cl.6)** |
| | | | G03F<br>C09D |

Der vorliegende Recherchenbericht wurde für alle Patentansprüche erstellt

| Recherchenort | Abschlußdatum der Recherche | Prüfer |
|---|---|---|
| DEN HAAG | 2.Juni 1995 | J.-M. DUPART |

**KATEGORIE DER GENANNTEN DOKUMENTE**

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument